# EUROPEAN PATENT APPLICATION

(11) **EP 2 426 727 A1**
(43) Date of publication of application: **07.03.2012**
(21) Application number: 10769573.6
(22) Date of filing: 24.03.2010
(51) Int. Cl.: H01L 31/04

(54) **SOLAR BATTERY DEVICE, AND SOLAR BATTERY MODULE USING THE SAME**

(30) Priority: 27.04.2009 JP 2009107903; 22.12.2009 JP 2009290014
(71) Applicant: Kyocera Corporation, Kyoto-shi Kyoto 612-8501 (JP)
(72) Inventor: ITO Naoya, Ise-shi Mie 516-8510 (JP)
(74) Representative: Keck, Stephan
(86) International application number: PCT/JP2010/055016
(87) International publication number: WO 2010/125874

(57) **Abstract**

It is aimed to provide a solar cell element and a solar cell module capable of reducing an output drop in a case where a crack occurs in the solar cell element. In order to achieve this object, the solar cell element includes a substrate body including a photoelectric conversion part, a plurality of first electrodes located at intervals on one main surface of the substrate body, and a crack guiding part located in a region positioned between a pair of adjacent first electrodes among the plurality of first electrodes when the substrate body is viewed or viewed through in plan view from the one main surface side and configured to guide a position of a crack occurring in the substrate body upon application of a load to the substrate body.

## Description

### Technical Field

The present invention relates to a solar cell element and a solar cell module including the same.

### Background Art

Solar cell modules are used in various places, which are also used under severe natural conditions. Therefore, the solar cell modules are required to keep the power generation efficiency even under those severe natural conditions.

In response to a such request, there is disclosed the technology of improving the load bearing performance of a light-transmitting substrate by provision of a reinforcing member that supports a solar cell module from a non-light-receiving surface side (for example, see Patent Document 1).

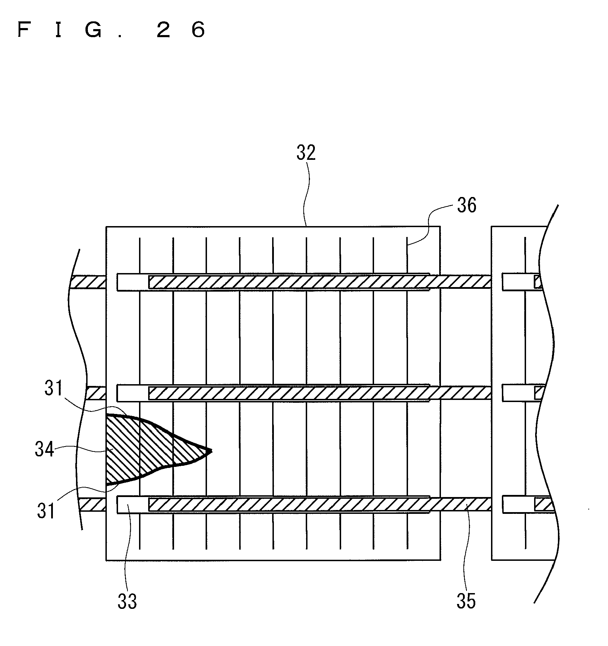

Unfortunately, upon application of a load by wind pressure or snow load, even in the solar cell module disclosed in Patent Document 1, the light-transmitting substrate is bent in accordance with the load and a crack occurs in a solar cell element at times. For example, as shown in FIG. 26, when cracks 31 occur in a solar cell element 32, a region 34 in which a finger electrode 36 and a bus bar electrode 33 are not electrically connected to each other is formed in some cases. In this case, the electrical power generated in a portion corresponding to the region 34 is not taken to a connecting conductor 35, leading to a drop in the output of a solar cell module.

### Prior Art Document

### Patent Document

Patent Document 1: Japanese Patent Application Laid-Open No. 09-148612 (1997)

### Summary of the Invention

### Problem to be solved by the Invention

An object of the present invention is to reduce a drop in the output in a case where cracks occur in a solar cell element.

### Means to solve the Problem

In order to solve the above-mentioned problem, a solar cell element according to a first aspect includes a substrate body including a photoelectric conversion part and a plurality of first electrodes located at intervals on one main surface of the substrate body. In addition, the solar cell element includes a crack guiding part located in a region positioned between a pair of adjacent first electrodes among the plurality of first electrodes when the substrate body is viewed or viewed through in plan view from the one main surface side and configured to guide a position of a crack occurring in the substrate body upon application of a load to the substrate body.

Further, a solar cell element according to a second aspect includes: a substrate body of a rectangular or square shape, including a photoelectric conversion part; and a plurality of first electrodes located at intervals on one main surface of the substrate body. The plurality of first electrodes are provided so as to extend along one side of the substrate body. Further, the substrate body includes, in a region located between the pair of adjacent first electrodes among the plurality of first electrodes, at least one of a groove part and a penetration part located along a longitudinal direction of the first electrodes when the substrate body is viewed or viewed through in plan view from the one main surface side.

### Effects of the Invention

According to the solar cell element of any of the first and second aspects, it is possible to reduce the occurrence of regions where power is not extracted by causing a crack to occur in a portion between the first electrodes of the substrate body. That is, according to the solar cell element of any of the first and second aspects, an output drop can be reduced even in a case where a crack occurs in the solar cell element.

### Brief Description of Drawings

FIG. 1 is a plan view illustrating a state in which solar cell modules according to first to fifth embodiments are viewed from a light-receiving surface side.
FIG. 2 is a cross-sectional view of the solar cell module taken along a cutting plane line II-II of FIG. 1.
FIG. 3 is a plan view illustrating the state in which a solar cell element according to the first embodiment is viewed from the light-receiving surface side.
FIG. 4 is a plan view illustrating the state in which the solar cell element according to the first embodiment is viewed from a non-light-receiving surface side.
FIG. 5 is a cross-sectional view of the solar cell element taken along a cutting plane line V-V of FIG. 3.
FIG. 6 is a plan view illustrating the state in which a solar element cell according to the second embodiment is viewed from the light-receiving surface side.
FIG. 7 is a plan view illustrating the state in which the solar cell element according to the second embodiment is viewed from the non-light-receiving surface side.
FIG. 8 is a cross-sectional view of the solar cell element taken along a cutting plane line VIII-VIII of FIG. 6.
FIG. 9 is a plan view illustrating the state in which a solar cell element according to the third embodiment is viewed from the non-light-receiving surface side.
FIG. 10 is a cross-sectional view of the solar cell element taken along a cutting plane line X-X of FIG. 9.
FIG. 11 is a cross-sectional view of the solar cell element taken along a cutting plane line XI-XI of FIG. 9.
FIG. 12 is a plan view illustrating the state in which a solar cell element according to the fourth embodiment is viewed from the non-light-receiving surface side.
FIG. 13 is a cross-sectional view of the solar cell element taken along a cutting plane line XIII-XIII of FIG. 12.
FIG. 14 is a plan view illustrating the state in which a solar cell element according to the fifth embodiment is viewed from the light-receiving surface side.
FIG. 15 is a plan view illustrating the state in which the solar cell element according to the fifth embodiment is viewed from the non-light-receiving surface side.
FIG. 16 is a cross-sectional view of the solar cell element taken along a cutting plane line XVI-XVI of FIG. 14.
FIG. 17 is a plan view illustrating the state before the solar cell element according to the fifth embodiment is split.
FIG. 18 is an image diagram illustrating a state after the solar cell element according to the fifth embodiment is split.
FIG. 19 is a schematic diagram illustrating the state when the solar cell element according to the fifth embodiment is split.
FIG. 20 is a cross-sectional view of the solar cell element taken along a cutting plane line XX-XX of FIG. 14.
FIG. 21 is a schematic diagram illustrating the state when the solar cell element is split.
FIG. 22 is a plan view illustrating a state in which a solar cell element according to a modification is viewed from the light-receiving surface side.
FIG. 23 is a plan view illustrating a state in which a solar cell element according to another modification is viewed from the light-receiving surface side.
FIG. 24 is a plan view illustrating a state in which a solar cell element according to still another modification is viewed from the light-receiving surface side.
FIG. 25 is a plan view illustrating a state in which cracks occur in the solar cell element according to the sill another modification.
FIG. 26 is a plan view illustrating a state in which cracks occur in a solar cell element of a conventional solar cell module.

### Embodiments for Carrying Out the Invention

Hereinafter, first to fifth embodiments of the present invention are described in order with reference to the accompanying drawings. The same reference symbols denote the portions having identical configurations and functions in the drawings, and the descriptions of those portions are omitted. Further, the drawings are schematically shown, where the sizes, positional relationship and the like of various configurations are not accurately shown in the drawings.

### <(1) First embodiment>

### <(1-1) Solar cell module>

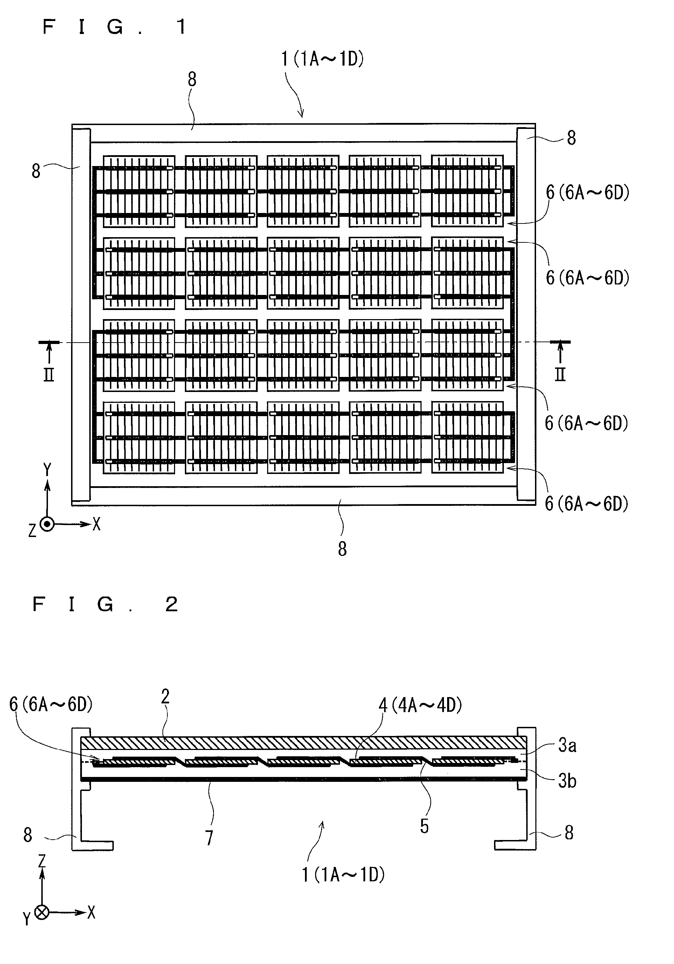

As shown in FIG. 1 and FIG. 2, a solar cell module 1 including solar cell elements according to a first embodiment of the present invention includes a laminate of a light-transmitting substrate 2, a filler 3a, a solar cell string 6, a filler 3b and a back surface sheet 7. The solar cell string 6 includes, for example, a plurality of solar cell elements 4 arranged in a line and connecting conductors 5 that electrically connect electrodes provided on main surfaces of the adjacent solar cell elements 4 among the plurality of solar cell elements 4. Further, a frame 8 may be provided to the solar cell module 1 around the laminate for protecting the laminate.

Next, the respective parts constituting the solar cell module 1 are described.

### <(1-2) Solar cell element>

The solar cell element 4 has the function of converting the light incident on the solar cell module 1 into electricity (photoelectric conversion function). The solar cell element 4 includes, for example, a substrate body 4s that is formed of a single crystal silicon substrate having a flat plate shape, a polycrystal silicon substrate having a flat plate shape or the like and serves as a photoelectric conversion part. Note that the photoelectric conversion part is not limited to the above-mentioned silicon substrate and may be of, for example, an amorphous silicon type, a CIS (copper, indium, selenium) type, a CIGS (copper, indium, gallium, selenium) type, or a thin film type including a GaAs layer.

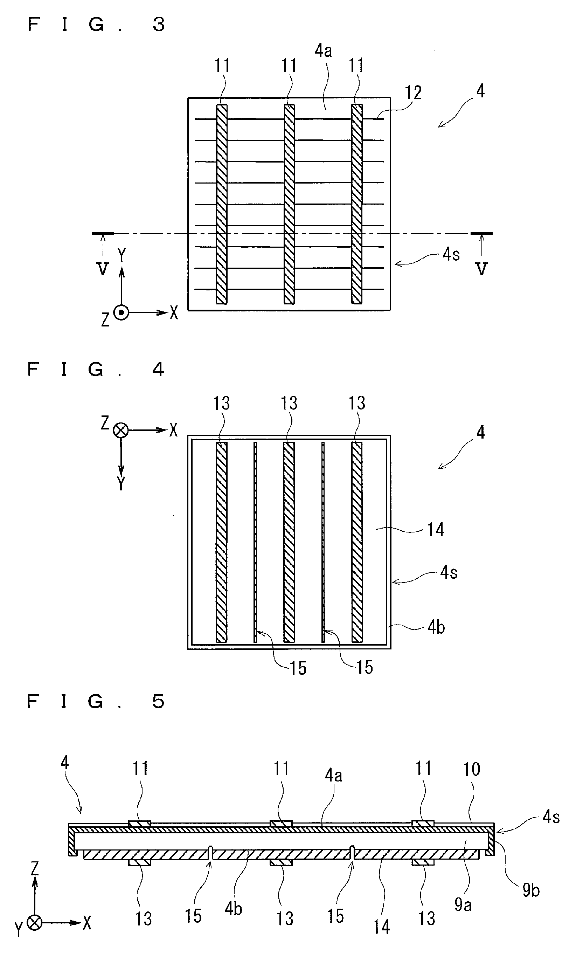

The substrate body 4s has a thickness of approximately 0.1 to 0.3 mm and includes an approximately square-shaped board surface with a side having a length of 150 to 160 mm. The substrate body 4s may have an approximately rectangular shape, an approximately circular shape or the like other than a square shape. In particular, from the viewpoint of a reduced spacing between solar cell elements to increase the number of solar cell elements for one solar cell module, the substrate body 4s preferably has a square shape or a rectangular shape. The substrate body 4s is mainly made of silicon, and includes a PN junction provided by junction of a bulk region 9a being a P-type semiconductor including a high content of P-type impurities such as boron and a diffusion layer 9b being an N-type semiconductor including a high content of N-type impurities such as phosphorus. As shown in FIG. 3 and FIG. 4, the substrate body 4s includes a first main surface 4a mainly forming a light-receiving surface on a surface side on which sunlight is received and a second main surface 4b mainly forming a non-light-receiving surface on which sunlight is not received on an opposite side to the first main surface 4a. The thus configured substrate body 4s generates carriers upon reception of sunlight or the like. Note that even the substrate body formed of a substrate other than a silicon substrate is capable of generating carriers similarly to the silicon substrate by providing a PN junction thereto.

As shown in FIG. 3 to FIG. 5, almost the entire surface of the first main surface 4a is covered with an antireflection film 10. The first main surface 4a is provided with a plurality of bus bar electrodes 11 as first electrodes and a plurality of finger electrodes 12 as second electrodes. Specifically, three bus bar electrodes 11 are extended at intervals so as not to intersect each other with an approximately parallel positional relationship. The bus bar electrodes 11 are provided along one side of the substrate body 4s. Meanwhile, the plurality of finger electrodes 12 are extended at intervals so as not to intersect each other with an approximately parallel positional relationship. In addition, each finger electrode 12 intersects the three bus bar electrodes 11 almost perpendicularly, and thus is electrically connected to the bus bar electrodes 11. The finger electrode 12 intersects the bus bar electrodes 11 almost perpendicularly, and thus is provided along the other side adjacent to the one side of the substrate body 4s.

The antireflection film 10 has a function of reducing the reflection of light incident upon the first main surface 4a. The antireflection film 10 is formed by, for example, deposition of silicon nitride (Si₃N₄) using a mono-silane gas or an ammonium gas in a plasma CVD device.

The finger electrode 12 has a function of collecting carriers generated in the substrate body 4s and transmitting those carriers to the bus bar electrodes 11 (that is, collector function of collecting the power generated in the substrate body 4s). The finger electrode 12 is formed by printing a paste for electrode formation on the first main surface 4a by screen printing and further baking the paste by burning at 600 to 800°C for approximately one to thirty minutes. The paste for electrode formation is obtained by adding a glass frit to the mixture of a silver powder and an organic vehicle, and is produced by, for example, adding 0.1 to 5 parts by weight of glass frit to 100 parts by weight of silver. The finger electrode 12 has a line width of, for example, approximately 50 to 200 µm.

The bus bar electrode 11 has a function of outputting the carriers transmitted from the finger electrodes 12 to the outside. The bus bar electrode 11 is formed in, for example, a similar manner to that of the finger electrode 12 and has a line width of approximately 1 to 3 mm. Note that the number of bus bar electrodes 11 is not limited to three and is only required to be at least two or more, which may be four or more.

As shown in FIG. 4 and FIG. 5, almost the entire surface of the second main surface 4b except for the edge of the second main surface 4b is covered with a collector electrode 14. Further, a plurality of (in this case, three) bus bar electrodes 13 are extended in an appropriately parallel manner without intersecting each other on the collector electrode 14.

The extending direction of the bus bar electrode 13 is approximately the same as the extending direction of the bus bar electrode 11 provided on the first main surface 4a. For this reason, in the solar cell element 4, the longitudinal direction of the region positioned between the pair of adjacent bus bar electrodes 13 is almost identical to the longitudinal direction of the region positioned between the pair of adjacent bus bar electrodes 11. Moreover, when the solar cell element 4 is viewed through in plan view from the first main surface 4a side (that is, light-transmitting substrate 2 side), the region in which a plurality of bus bar electrodes 11 are provided and the region in which a plurality of bus bar electrodes 13 are provided almost overlap each other. To view through in plan view from the first main surface 4a side means to view through an object located in the direction of the line of sight such that the line of sight is approximately perpendicular to the first main surface 4a.

The collector electrode 14 has a function of collecting carriers generated in the substrate body 4s and transmitting the carriers to the electrically-connected bus bar electrodes 13 (that is, collector function of collecting the power generated in the substrate body 4s). The collector electrode 14 is formed by, for example, printing a paste for electrode formation on the second main surface 4b by screen printing and further baking the paste. The paste for electrode formation is obtained by adding a glass frit to the mixture of an aluminum powder and an organic vehicle, and is produced by, for example, adding 0.1 to 5 parts by weight of glass frit to 100 parts by weight of aluminum. The collector electrode 14 has a thickness of, for example, approximately 15 to 50 µm.

The bus bar electrode 13 is electrically connected to the collector electrode 14 and has a function of outputting the carriers transmitted from the collector electrode 14 to the outside. The bus bar electrode 13 is formed in, for example, a similar manner to that of the finger electrode 12 described above and has a line width of approximately 3.5 to 7 mm and a thickness of approximately 10 to 20 µm. Note that the number of bus bar electrodes 13 is not limited to three and is only required to be at least two or more, which may be four or more similarly to the bus bar electrode 11.

On the second main surface 4b side of the substrate body 4s, crack guiding parts 15 are each formed between the pair of adjacent bus bar electrodes 13 almost from one end to the other end of the substrate body 4s along the longitudinal direction of the regions located between the pair of adjacent bus bar electrodes 13. In another respect, when the substrate body 4s is viewed through in plan view from the first main surface 4a side (that is, light-transmitting substrate 2 side), the crack guiding parts 15 are each provided in the region located between the pair of adjacent bus bar electrodes 11 among the plurality of bus bar electrodes 11.

The crack guiding part 15 has a function of guiding a crack occurring in the substrate body 4s in a predetermined direction. Here, a crack refers to a crack, a fracture or the like occurring in the substrate body 4s and includes one that splits the substrate body 4s and one that causes a crack or the like in the surface layer part of the substrate body 4s. Specifically, the crack guiding part 15 according to the present embodiment includes a groove part extending from the surface of the collector electrode 14 to the inside of the substrate body 4s in the depth direction, and the bottom of the groove part is formed by the substrate body 4s. In the crack guiding part 15, the surface forming the bottom of the groove part and the portion in the vicinity thereof in the substrate 4s correspond to the portions on which a stress is concentrated (hereinafter, referred to as a "stress concentrating part") upon application of the load to the solar cell element 4 from the light-transmitting substrate 2 side. Therefore, it may be considered that the stress concentrating part is included in the crack guiding part 15. In the solar cell element 4, the mechanical strength is weaker in the portion in which the crack guiding part 15 is provided compared with its surrounding portion.

Accordingly, for example, upon application of an excessive load or a load such as a stress to the solar cell element 4 from the light-transmitting substrate 2 side, a crack occurs in the substrate body 4s along the groove part forming the crack guiding part 15 due to the presence of the crack guiding part 15 in some cases. Even when the crack occurs, however, the portion that is not electrically connected to the bus bar electrode 11 is less likely to occur in the finger electrode 12. That is, even when a crack that splits the finger electrode 12 occurs along the crack guiding part 15, an output drop is reduced in the solar cell element 4 because the electrical connection between the bus bar electrode 11 and the finger electrode 12 is maintained. Further, the solar cell element 4 in which a crack has occurred at a desired position along the crack guiding part 15 functions as a plurality of solar cell elements each including a light-receiving surface of a small area. This leads to a reduction of an output drop in the solar cell element 4 in its entirety.

That is, the solar cell element 4 is capable of generating a crack at a predetermined position in the substrate body 4s such that an output drop of the solar cell module 1 is less likely to occur. Specifically, the crack that has occurred in the substrate body 4s can be guided in a desired direction in the solar cell element 4. In addition, the fracture of solids has a scale effect that a strength is increased as the dimension of a solid becomes smaller. Therefore, as a result of the solar cell element 4 being split due to a crack and functioning as a plurality of solar cell elements including a light-receiving surface of a small area, the upper limit of the load application strength increases.

Even if a crack occurs in the solar cell element 4 along the crack guiding part 15, the forms of the solar cell element 4 and the solar element string 6 are maintained owing to the presence of the connecting conductors 5 and the fillers 3a and 3b. This results in that the function of the solar cell module 1 is maintained even when the solar cell element 4 is split due to a crack.

The groove part forming the crack guiding part 15 is formed by, for example, forming the configuration of the solar cell element 4 or the solar cell string 6 except for the crack guiding part 15 and then removing a part of the configuration by laser processing or the like. Specifically, for example, the solar cell element 4 or the solar cell string 6 in which the crack guiding part 15 is not formed is first fixed at a predetermined position on a table movable individually in the orthogonal directions of two axes X and Y in a plane. Then, the laser light of a YAG laser (having a wavelength of 1.06 µm, a frequency of oscillation of 40 to 60 kHz and a power density of 107 to 108 W/cm²) is emitted from directly above the surface where the crack guiding part 15 will be formed, to thereby form a groove part.

It is preferable in this case that the groove part forming the crack guiding part 15 have the depth of approximately 5 to 50% of the thickness of the substrate body 4s such that a crack along the crack guiding part 15 is guided in a desired direction more reliably.

### <(1-3) Light-transmitting substrate>

The light-transmitting substrate 2 has a function of protecting the solar cell elements 4. Examples of the material for the light-transmitting substrate 2 include various glasses such as a white toughened glass, a white glass, a toughened glass, and a heat-reflecting glass, and a polycarbonate resin, which are required to allow the light having such a wavelength to be photoelectrically converted by the solar cell element 4 to pass therethrough. In particular, it is preferable that the light-transmitting substrate 2 be a white toughened glass having a thickness of approximately 3 to 5 mm or a synthetic resin substrate (made of a polycarbonate resin or the like) having a thickness of approximately 5 mm.

### <(1-4) Filler>

The fillers 3a and 3b have a function of sealing the solar cell elements 4. Examples of the fillers 3a and 3b include one mainly containing ethylene-vinyl acetate copolymer (EVA) or polyvinyl butyral (PVB), which is shaped into a sheet having a thickness of approximately 0.4 to 1 mm by an extruder and is then cut into a desired size.

The fillers 3a and 3b contain a cross-linking agent having the property of linking molecules of EVA or the like. For example, an organic peroxide that decomposes at a temperature of 70 to 180°C and generates a radical can be used as the cross-linking agent. Examples of the organic peroxide include 2,5-dimethyl-2,5-bis(t-butylperoxy)hexane and tert-hexyl peroxypivalate, which is preferably contained at a ratio of approximately one part by mass to 100 parts by mass of EVA.

Further, in addition to the above-mentioned EVA and PVB, a thermosetting resin or a resin obtained by containing a cross-linking agent in a thermoplastic resin and providing the thermosetting property is preferably used as the materials for the fillers 3a and 3b and, for example, an acrylic resin, a silicone resin, an epoxy resin or an ethylene-ethyl acrylate copolymer (EEA) can be used.

### <(1-5) Connecting conductor>

The connecting conductor 5 has a function of electrically connecting the electrodes provided on the main surfaces of the solar cell elements 4 adjacent to each other. In the solar cell module 1, the connecting conductor 5 electrically connects the bas bar electrode 11 on the front surface side of one solar cell element 4 of two adjacent solar cell elements 4 to the bus bar electrode 13 on the back surface side of the other solar cell element 4 thereof.

One obtained by forming a solder coating having a thickness of approximately 20 to 70 µm on the entire surface of a wire material of a copper foil or the like by, for example, plating or dipping may be preferably used as the connecting conductor 5. The connecting conductor 5 is secured to the bus bars 11 and 13 by a method such as spot welding. For example, in a case where the substrate body 4s including a square board surface having a side of 150 mm is used, it suffices that the connecting conductor 5 has a width of approximately 1 to 3 mm and a length of approximately 260 to 290 mm.

Upon application of an excessive load to the solar cell element 4 from the light-transmitting substrate 2 side, on occasions, the stress tends to be concentrated on the portion in the vicinity of the edge of the portion in which the connecting conductor 5 and the solar cell element 4 are secured to each other, in the substrate body 4s, that is, the portion in the vicinity of the edge of the connecting conductor 5 along the extending direction of the connecting conductor 5. In such cases, it is preferable that the crack guiding part 15 be provided along the edge in the vicinity of the edge on at least one side of the connecting conductor 5.

### <(1-6) Back surface sheet>

The back surface sheet 7 has a function of protecting the filler 3b and the solar cell elements 4. For example, polyvinyl fluoride (PVF), polyethylene terephtharate (PET), polyethylene naphtalate (PEN) or a lamination thereof is preferably used as the material for the back surface sheet 7.

### <(2) Second embodiment>

Crack guiding parts 15A are formed in a solar cell module 1A including solar cell elements according to a second embodiment by providing penetration parts in the substrate body.

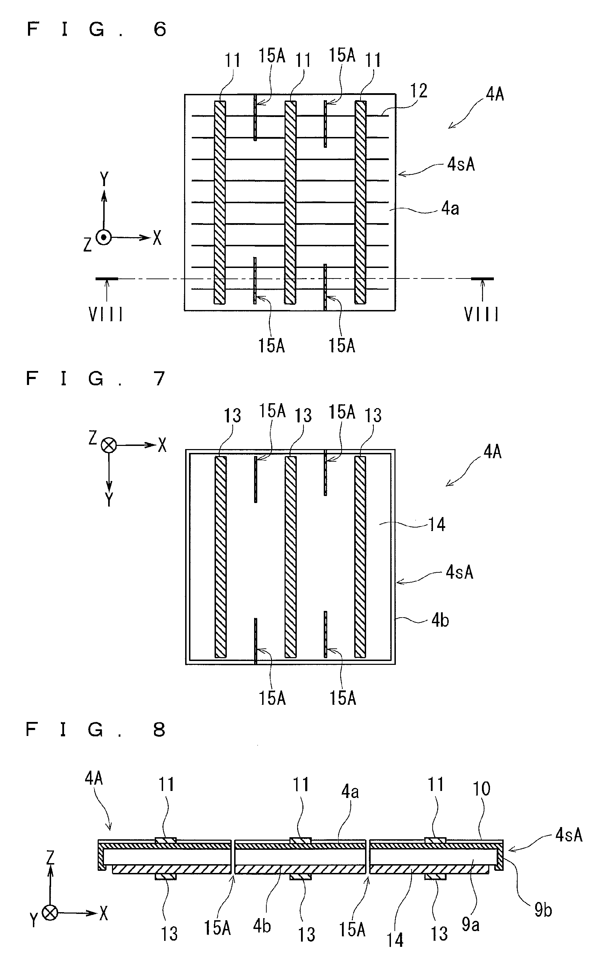

As shown in FIG. 6 to FIG. 8, the solar cell module 1A according to the second embodiment comprises a configuration in which the crack guiding part 15 is replaced with the crack guiding part 15A having a different shape, differently from the solar cell module 1 according to the first embodiment. As a result of the replacement, differently from the solar cell module 1 according to the first embodiment, the solar cell module 1A according to the second embodiment comprises a configuration in which the solar cell string 6, the solar cell element 4 and the substrate body 4s are replaced with a solar cell string 6A, a solar cell element 4A and a substrate body 4sA that have the same function but a somewhat different configuration.

The crack guiding part 15A is configured to include slit-like portions (also referred to as "penetration parts") provided in the substrate body 4sA. Specifically, in the substrate body 4sA, in a case where the substrate body 4sA is viewed and viewed through in plan view from the first main surface 4a side (that is, light-transmitting substrate 2 side), the crack guiding parts 15A are each provided in a region positioned between the pair of adjacent bus bar electrodes 11. To view in plan view from the first main surface 4a side means to view an object such that the line of sight is approximately perpendicular to the first main surface 4a.

Each penetration part is formed so as to extend from the front surface to the back surface of the solar cell element 4A. That is, each penetration part is formed so as to penetrate through the laminate comprised of the antireflection film 10, the diffusion layer 9b and bulk region 9a forming the substrate body 4sA and the collector electrode 14.

It is preferable that as shown in FIG. 6 and FIG. 7, the crack guiding parts 15A be each formed in a part of a portion extending from one end to the other end of the substrate body 4sA along the longitudinal direction of the region located between the pair of adjacent bus bar electrodes 11 such that the solar cell element 4A is not split into several regions in manufacturing the solar cell module 1A.

In the crack guiding part 15A, the surface forming the distal end of the penetration part and the portion in the vicinity thereof in the substrate 4sA correspond to the stress concentrating parts on which the stress is concentrated upon application of the load to the solar cell element 4A from the light-transmitting substrate 2 side. Therefore, it may be considered that the stress concentrating part is included in the crack guiding part 15A.

In terms of a reduction of a possibility that a crack may spread in a direction different from the extending direction of the bus bar electrode 11, as shown in FIG. 6 and FIG. 7, each penetration part is preferably formed linearly along the longitudinal direction of the region located between the pair of adjacent bus bars 11 (and bus bar electrodes 13), and more preferably, a plurality of penetration parts are arranged approximately in a line. It is possible to form each penetration part by, for example, forming the configuration of the solar cell element 4A or the solar cell string 6A except for the crack guiding part 15A and then removing a part of the configuration by laser processing or the like.

Upon application of the load from the light-transmitting substrate 2 side, in the solar cell element 4A, a crack occurs preferentially in the region between a plurality of (two in FIG. 6 to FIG. 8) penetration parts arranged approximately in a line between the adjacent bus bar electrodes 11. In other words, the region extending along the extended line of the penetration part that links the plurality of penetration parts arranged approximately in a line in the substrate body 4sA corresponds to the region in which a crack tends to occur preferentially.

Alternatively, as shown in FIG. 6 and FIG. 7, a penetration part including an aperture on the end surface of the substrate body 4sA may be used as the penetration part forming the crack guiding part 15A. In such a manner, a crack tends to occur starting from the crack guiding part 15A, and the penetration part can be formed by a simple method such as cutting. The penetration part forming the crack guiding part 15A can be formed relatively with ease even if the solar cell elements 4A are disposed along a curved surface.

In the solar cell module 1A according to the second embodiment that comprises the above-mentioned configuration, as in the first embodiment, the electrical connection between the bus bar electrode 11 and the finger electrode 12 is maintained even when a crack that splits the finger electrode 12 occurs along the extended line of the crack guiding part 15A, resulting in a reduction of output drop.

Further, the crack guiding part 15A is formed of the penetration part, and accordingly compared with the solar cell element 4 according to the first embodiment in which the crack guiding part 15 is configured to include a groove part, the mechanical strength of the solar cell element 4A in the vicinity of the crack guiding part 15A reduces. As a result, the solar cell element 4A is configured such that a crack occurring more tends to be guided in a predetermined direction.

### <(3) Third embodiment>

In a solar cell module 1B including solar cell elements according to a third embodiment, a crack guiding part 15B is formed to comprise a plurality of penetration holes that penetrate a substrate body and are arranged in a line.

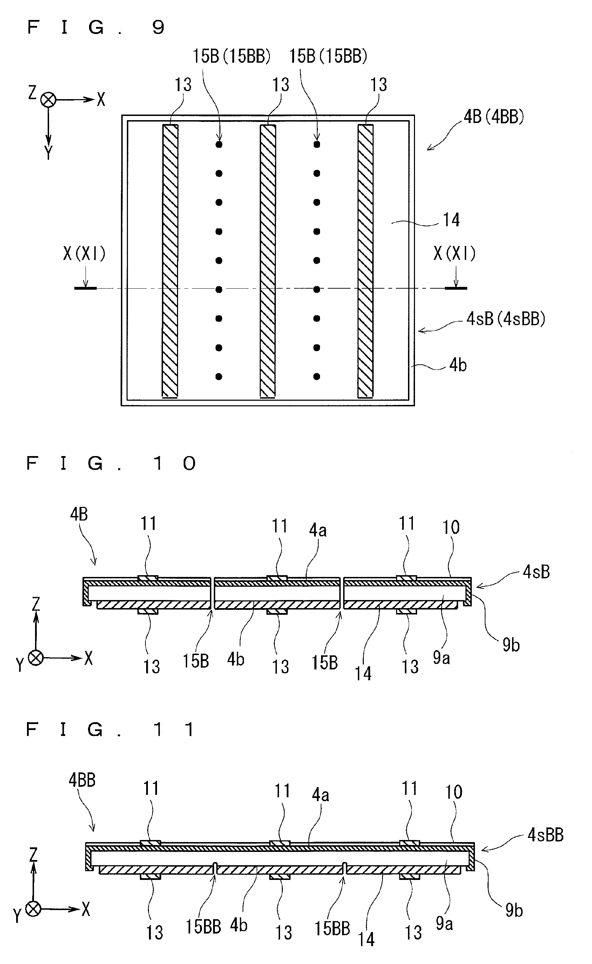

As shown in FIG. 9 and FIG. 10, the solar cell module 1B according to the third embodiment comprises a configuration in which the crack guiding part 15 is replaced with the crack guiding part 15B having a different shape, differently from the solar cell module 1 according to the first embodiment. As a result of the replacement, differently from the solar cell module 1 according to the first embodiment, the solar cell module 1B according to the third embodiment comprises a configuration in which the solar cell string 6, the solar cell element 4 and the substrate body 4s are replaced with a solar cell string 6B, a solar cell element 4B and a substrate body 4sB that have the same function but a somewhat different configuration.

The crack guiding part 15B is configured to comprise a plurality of penetration holes arranged in the substrate body 4sB. Specifically, in the case where the substrate body 4sB is viewed and viewed through in plan view from the first main surface 4a side (light-transmitting substrate 2 side), the crack guiding parts 15B are each provided in the region located between the pair of adjacent bus bar electrodes 11 in the substrate body 4sB.

Each penetration hole is formed so as to extend from the front surface to the back surface of the solar cell element 4B. That is, each penetration hole is formed to extend from the front surface to the back surface of the laminate comprised of the antireflection film 10, the diffusion layer 9b and bulk region 9a forming the substrate body 4sB and the collector electrode 14. Note that each penetration hole includes the interior space of, for example, approximately cylindrical shape.

It is possible to form each penetration hole as described above by, for example, forming the configuration of the solar cell element 4B or the solar cell string 6B except for the crack guiding part 15B and then removing a part of the configuration by laser processing or the like. Specifically, for example, the solar cell element 4b or the solar cell string 6B except for the crack guiding part 15B is first fixed at a predetermined position on a table movable individually in the orthogonal directions of two axes X and Y in a plane. Then, the laser light of a YAG layer or the like is emitted from directly above the surface where the crack guiding part 15 will be formed, to thereby form each penetration hole.

In the crack guiding part 15B, the surface forming the inner wall part of each penetration hole and the portion in the vicinity thereof in the substrate body 4sB correspond to the stress concentrating parts on which the stress is concentrated upon application of the load to the solar cell element 4B from the light-transmitting substrate 2 side.

Upon application of an excessive load to the solar cell element 4B from the light-transmitting substrate 2 side, a crack occurs preferentially in the region along a plurality of penetration holes arranged between the pair of adjacent bus bar electrodes 11, that is, in the region linking the plurality of penetration holes. In other words, the region that links a plurality of penetration holes forming the crack guiding part 15B of the substrate body 4sB corresponds to the region in which a crack tends to occur preferentially.

In terms of a reduction of a possibility that a crack may spread in a direction different from the extending direction of the bus bar electrode 11, as shown in FIG. 9, it is preferable that a plurality of penetration holes forming the crack guiding part 15B be linearly arranged in the region located between the pair of adjacent bus bar electrodes 11 (and bus bar electrodes 13). In this case, a crack advances along the plurality of penetration holes linearly arranged.

In the solar cell module 1B including the solar cell elements according to the third embodiment that comprise the above-mentioned configuration, as in the first and second embodiments, the electrical connection between the bus bar electrode 11 and the finger electrode 12 is maintained even when a crack that splits the finger electrode 12 occurs along the crack guiding part 15B, resulting in a reduction in output drop.

The crack guiding part 15B is formed such that a plurality of penetration holes are arranged at intervals. Accordingly, the solar cell element 4B according to the third embodiment has a larger mechanical strength compared with the solar cell elements 4 and 4A according to the first and second embodiments in which the crack guiding parts 15 and 15A are configured by providing linear groove parts and linear penetration parts therein.

As shown in FIG. 9 and FIG. 11, a solar cell element 4BB may be used, which is provided with hole parts (groove parts) including the bottom surface part and interior space of an approximately cylindrical shape in place of the penetration holes. Differently from the solar cell element 4B, the solar cell element 4BB comprises the configuration in which the crack guiding part 15B configured such that a plurality of penetration holes are arranged therein is replaced with a crack guiding part 15BB configured such that a plurality of hole parts are arranged therein. As a result of the replacement, differently from the solar cell element 4B described above, the solar cell element 4BB comprises a configuration in which the substrate body 4sB is replaced with a substrate body 4sBB that has the same function but a somewhat different configuration.

A plurality of hole parts forming the crack guiding part 15BB are not limited to ones provided on the second main surface 4b side and, for example, it suffices that those are provided on at least one main surface side of the first main surface 4a side and the second main surface 4b side of the substrate body 4sBB. In terms of maintaining the power generation efficiency in the solar cell element 4BB, as shown in FIG. 9 and FIG. 11, the crack guiding parts 15BB are preferably provided on the second main surface 4b side of the substrate body 4sBB.

### <(4) Fourth embodiment>

In a solar cell module 1C including solar cell elements according to a fourth embodiment, a crack guiding part 15C is formed of a coating part that is integrally formed with the substrate body separately from the substrate body.

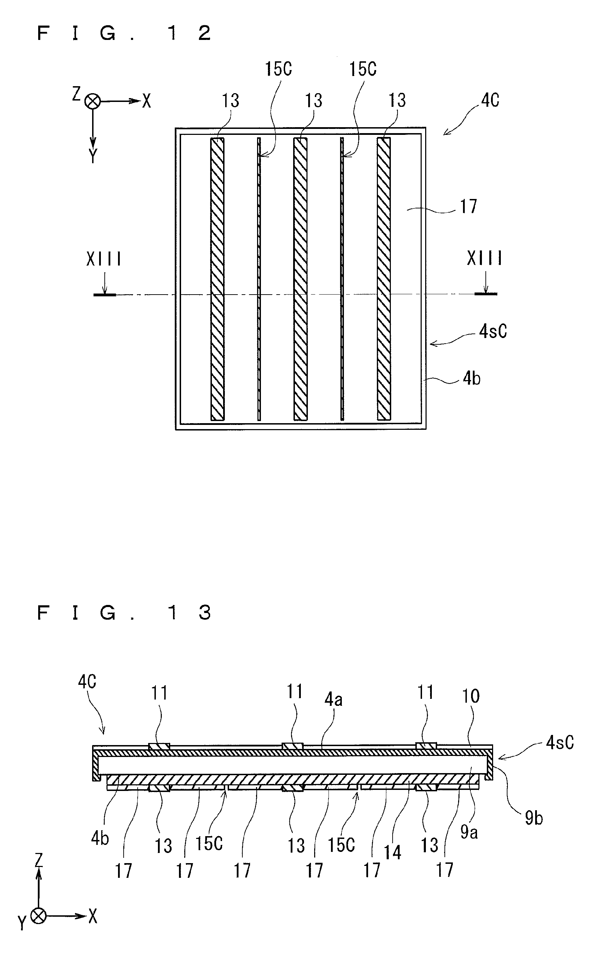

As shown in FIG. 12 and FIG. 13, the solar cell module 1C according to the fourth embodiment comprises a configuration in which the crack guiding part 15 is replaced with the crack guiding part 15C formed of the coating part 17, differently from the solar cell module 1 according to the first embodiment. As a result of the replacement, differently from the solar cell module 1 according to the first embodiment, the solar cell module 1C according to the fourth embodiment comprises a configuration in which the solar cell string 6, the solar cell element 4 and the substrate body 4s are replaced with a solar cell string 6C, a solar cell element 4C and a substrate body 4sC that have the same function but a somewhat different configuration.

On the second main surface 4b side of the substrate body 4sC, as in the first to third embodiments, the crack guiding parts 15C are each formed between the pair of adjacent bus bar electrodes 13 in an approximately linear manner almost from one end to the other end of the substrate body 4sC along the longitudinal direction of the region positioned between the pair of adjacent bus bar electrodes 13. In another respect, when the substrate body 4sC is viewed through in plan view from the first main surface 4a side (that is, light-transmitting substrate 2 side), the crack guiding parts 15C are each provided in the region positioned between the pair of adjacent bus bar electrodes 11 among a plurality of bus bar electrodes 11.

On the second main surface 4b side of the substrate body 4sC, the crack guiding part 15C is configured to include a groove-like recess defined by the formation of a portion (hereinafter, also referred to as a "forming part") that is coated with the coating part 17 and a portion (hereinafter, also referred to as a "non-forming part") that is not coated with the coating part 17 on the collector electrode 14. That is, the recess is formed of the coating part 17 and the surface of the collector electrode 14. In the manner in which the collector electrode 14 is not formed in the region in which the recess is positioned, the recess is formed of the coating part 17 and the second main surface 4b of the substrate body 4sC. That is, there are the manner in which the coating part 17 is directly applied onto the substrate body 4sC and the manner in which the coating part 17 is applied to the substrate body 4sC through another layer (in this case, collector electrode 14).

In this case, the coating part 17 is formed on the surface of the collector electrode 14 provided on the second main surface 4b, with a plurality of linear penetration parts. The penetration part corresponds to the interior space of each groove-like recess. Examples of the material forming the coating part 17 include various resins such as an epoxy resin, and the coating part 17 can be deposited by an application method using a spray, a brush or the like.

In the solar cell element 4C, the portion in which the coating part 17 is not formed has a smaller mechanical strength compared with the portion in which the coating part 17 is formed. Accordingly, the surface part of the collector electrode 14 in which the crack guiding part 15C is provided and the portion in the vicinity thereof correspond to the stress concentrating parts on which the stress is concentrated upon application of the load to the solar cell element 4C from the light-transmitting substrate 2 side.

Therefore, for example, upon application of an excessive load to the solar cell element 4 from the light-transmitting substrate 2 side, a crack occurs in the substrate body 4sC along the groove-like recess forming the crack guiding part 15C in the solar cell element 4C. Even when the crack occurs, however, the portion that is not electrically connected to the bus bar electrode 11 is less likely to occur in the finger electrode 12, similarly to the solar cell module 1 according to the first embodiment. Accordingly, an output drop is reduced in the solar cell element 4C.

In the solar cell element 4C, the solar cell element 4C is reinforced from the second main surface 4b side by the provision of the coating part 17, leading to an improvement of the mechanical strength of the solar cell element 4C.

As to the crack guiding part 15C, a groove-like recess formed by varying the thickness of the coating part 17 may be used in place of the recess defined by the formation of the forming part of the coating part 17 and the non-forming part of the coating part 17. Alternatively, the type in which one crack guiding part 15C comprises a configuration in which a plurality of recesses are arranged is also conceivable. Examples of the recess include groove-like and hole-like recesses.

### <(5) Fifth embodiment>

In a solar cell module 1D including solar cell elements according to a fifth embodiment, a crack guiding part 15D is formed of a support provided separately from the substrate body.

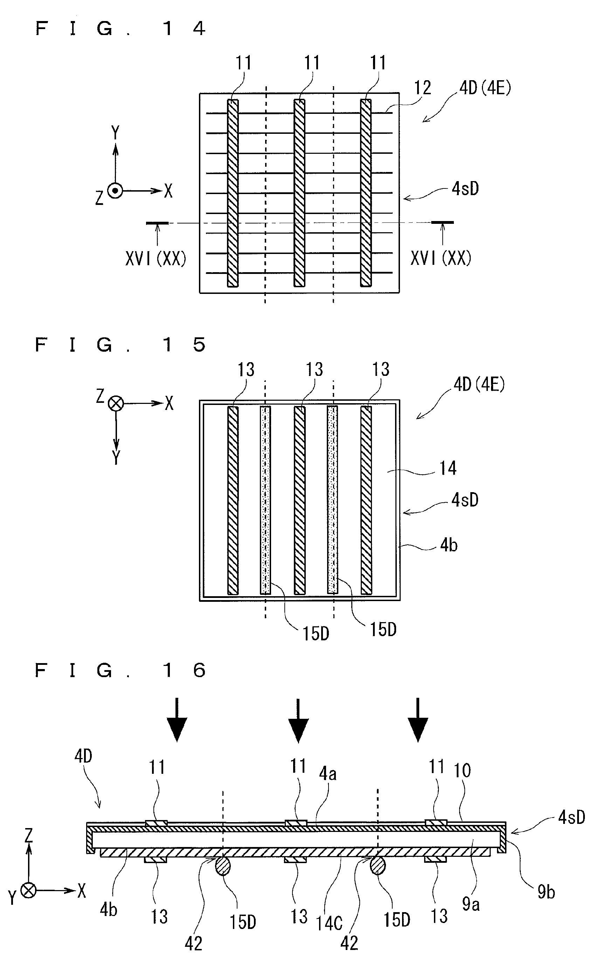

As shown in FIG. 14 to FIG. 16, the solar cell module 1D according to the fifth embodiment comprises a configuration in which the crack guiding part 15 is replaced with a crack guiding part 15D formed of a rod-like support (hereinafter, referred to as a rod-like body), differently from the solar cell module 1 according to the first embodiment. As a result of the replacement, differently from the solar cell module 1 according to the first embodiment, the solar cell module 1D according to the fifth embodiment comprises a configuration in which the solar cell string 6, the solar cell element 4 and the substrate body 4s are replaced with a solar cell string 6D, a solar cell element 4D and a substrate body 4sD that have the same function but a somewhat different configuration.

In the solar cell element 4D, when the substrate body 4sD is viewed through in plan view from the first main surface 4a side (that is, light-transmitting substrate 2 side), the crack guiding parts 15D are each provided in the region positioned between the pair of adjacent bus bar electrodes 11 among a plurality of bus bar electrodes 11. Specifically, the crack guiding parts 15D are each provided between the pair of adjacent bus bar electrodes 13 in an approximately linear manner almost from one end to the other end of the solar cell element 4D along the longitudinal direction of the regions positioned between the pair of adjacent bus bar electrodes 13.

For example, the rod-like body forming the crack guiding part 15D has an oval cross section and is formed of a material that has high rigidity such as metals including aluminum and stainless steel and resins including an ABS resin, a denatured PPE resin and a denatured PPO resin. The cross-sectional shape of the rod-like body may be circular or polygonal such as triangular or quadrangular. Moreover, the support forming the crack guiding part 15D is not limited to a rod-like body and, for example, may comprise a configuration in which a plurality of spherical or polygonal support members are arranged in a line.

In the present embodiment, the crack guiding part 15D abuts against the surface of the collector electrode 14C. In this case, the rod-like body is fixed to the surface of the collector electrode 14C with an adhesive. Meanwhile, a part of the filler 3b may be interposed in the space between the rod-like body and the collector electrode 14C. Further, the collector electrode 14 is not required to be formed in the region against which the rod-like body abuts, and the rod-like body may be fixed to the surface of the substrate body 4sD with an adhesive. That is, a rod-like body as a first support may be in direct contact with the substrate body 4sD or may be in indirect contact with the substrate body 4sC through the collector electrode 14C or the like. It is possible to easily form the crack guiding part 15D as described above by providing the filler 3b in the state in which a rod-like body is arranged, irrespective of the design of the electrode in the solar cell element 4D. On this occasion, the rod-like body is fixed with the filler 3b.

In the solar cell element 4D as described above, a region (abutment region) 42 in which the crack guiding part 15D abuts against the collector electrode 14C of the substrate body 4sD and the portion in the vicinity thereof correspond to the stress concentrating parts on which the stress is concentrated upon application of the load to the solar cell element 4D from the light-transmitting substrate 2 side.

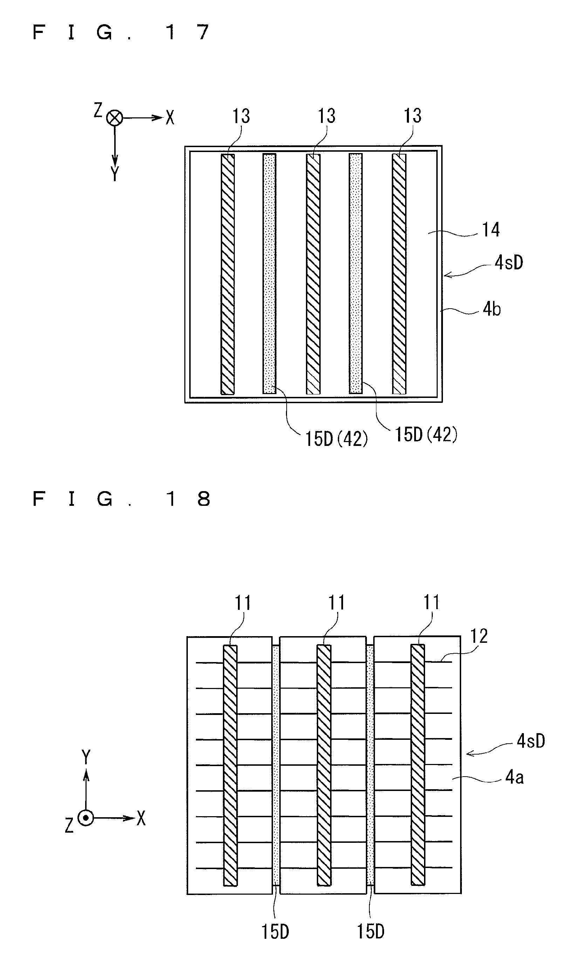

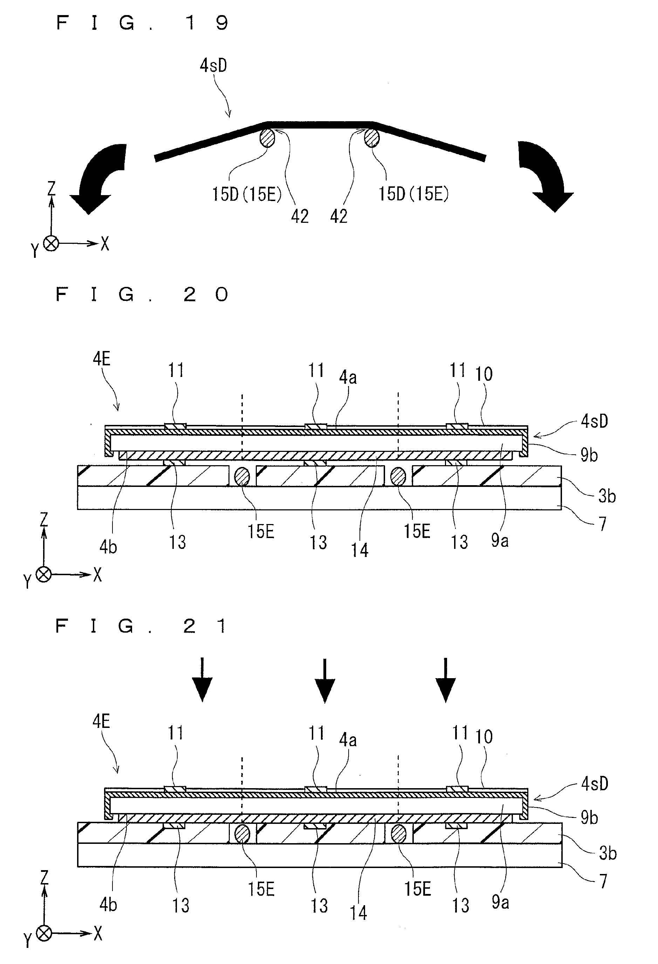

For example, upon application of an excessive load to the solar cell element 4D from the light-transmitting substrate 2 side, a crack occurs in the substrate body 4sD along the crack guiding part 15D (that is, abutment region 42) due to the presence of the crack guiding part 15D. Specifically, as shown in FIG. 17, cracks occur in the substrate body 4sD with the abutment regions 42 being the fulcrums and, as shown in FIG. 18, the substrate body 4sD is split. Specifically, as shown in FIG. 19, the stress is concentrated on the abutment regions 42 and the vicinities thereof upon application of a bending stress to the substrate body 4sD, and cracks occur preferentially along the abutment regions 42. In this case, as shown in FIG. 18, the crack guiding part 15D may be bonded to two split substrates 4sD or may be bonded to at least one substrate body 4sD among the substrates 4sD that have been split and become smaller (in the present embodiment, split into three).

As described above, similarly to the solar cell modules 1 and 1A to 1C according to the first to fourth embodiments, the electrical connection between the bus bar electrode 11 and the finger electrode 12 is maintained also in the solar cell module 1D according to the fifth embodiment, resulting in a reduction of output drop.

The crack guiding part 15D may be provided on the first main surface 4a side (that is, light-transmitting substrate 2 side) of the substrate body 4sD. Note that in terms of maintaining power generation efficiency in the solar cell module 1D by securing a light-receiving area, it is preferable that the crack guiding part 15D be provided on the second main surface 4b side of the substrate body 4sD.

Alternatively, there may be used a solar cell element 4E that comprises a configuration in which a rod-like body does not abut against the collector electrode 14C in the state in which a load is not applied to the solar cell element 4D from the light-transmitting substrate 2 side, and a rod-like body as a second support abuts against the collector electrode 14C upon the application of a load to the solar cell element 4D from the light-transmitting substrate 2 side. Specifically, for example, it is the configuration in which crack guiding parts 15E including a rod-like body in the space of the filler 3b are arranged as shown in FIG. 20. With the above-mentioned configuration, as shown in FIG. 21, elastic deformation that makes the thickness of the filler 3b smaller occurs upon application of a load to the solar cell element 4E from the light-transmitting substrate 2 side, and the rod-like body forming the crack guiding body 15E abuts against the collector electrode 14C. Note that the collector electrode 14 is not required to be formed in the region against which the rod-like body abuts, and the rod-like body may directly abut against the surface of the substrate body 4sD.

### <(6) Modifications>

The present invention is not limited to the embodiments described above, and numerous modifications and variations can be devised in the described aspects without departing from the scope of the invention.

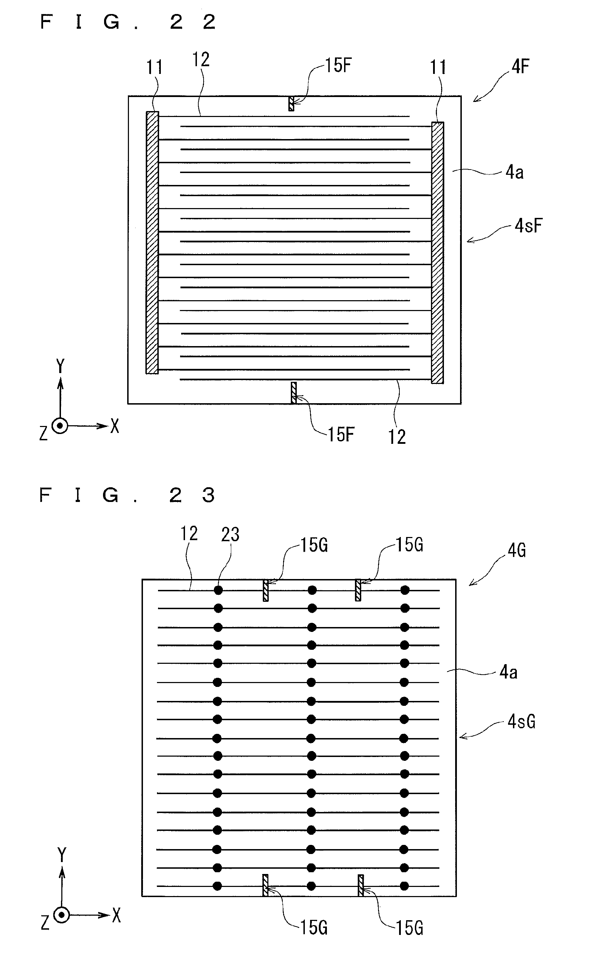

For example, each finger electrode 12 is provided so as to intersect a plurality of bus bar electrodes 11 in the first to fifth embodiments described above, which is not limited thereto. As shown in FIG. 22, for example, a solar cell element 4F is conceivable, where a pair of comb-like electrodes each including a configuration in which a plurality of finger electrodes 12 are provided from one bus bar electrode 11 in a direction perpendicular to its extending direction are provided on the first main surface 4a of a substrate body 4sF.

In the solar cell element 4F, for example, one bus bar electrode 11 is extended in the vicinity of an end portion on one side (+X side) of the substrate body 4sF along a Y direction, while the other bus bar electrode 11 is extended in the vicinity of an end portion on the other side (-X side) of the substrate body 4sF along the Y direction. Then, the finger electrodes 12 that are the comb-like electrodes on the other side are arranged one by one in each space between the finger electrodes 12 that are the comb-like electrodes on one side. That is, the finger electrodes 12 that are a pair of comb-like electrodes are arranged in an alternate manner. In the substrate body 4sF, a groove part forming a crack guiding part 15F is extended along the extending direction of the bus bar electrode 11 in the region between a pair of bus bar electrodes 11.

However, in terms of making it difficult to generate a portion that does not contribute to collecting power due to the occurrence of a crack in the finger electrode 12, it is preferable that each finger electrode 12 be extended so as to intersect each of the pair of adjacent bus bar electrodes 11 as in the first to fifth embodiments.

Further, a plurality of bus bar electrodes 11 are provided on the first main surface 4a side of the substrate body 4s, 4sA to 4sD, 4sBB in the first to fifth embodiment, which is not limited thereto. For example, a plurality of bus bar electrodes 11 may be provided on the second main surface 4b side of a substrate body 4sG, and the plurality of bus bar electrodes 11 may be electrically connected to a plurality of finger electrodes 12 individually through through-holes 23 filled with a conductive material, as shown in FIG. 23.

FIG. 23 illustrates the configuration in which three lines of through-holes (hereinafter, referred to as "through-hole lines") including a plurality of through-holes 23 linearly arranged along the direction in which the bus bar electrodes 11 are extended are provided. In the region between each pair of adjacent through-hole lines, a groove part forming a crack guiding part 15G is extended along the extending direction of the bus bar electrode 11.

In terms of visually checking whether or not the bus bar electrode 11 and the finger electrode 12 are disconnected from each other, it is preferable that the bus bar electrode 11 and the finger electrode 12 be provided on the same main surface side of the substrate body 4s, 4sA to 4sD, 4sBB.

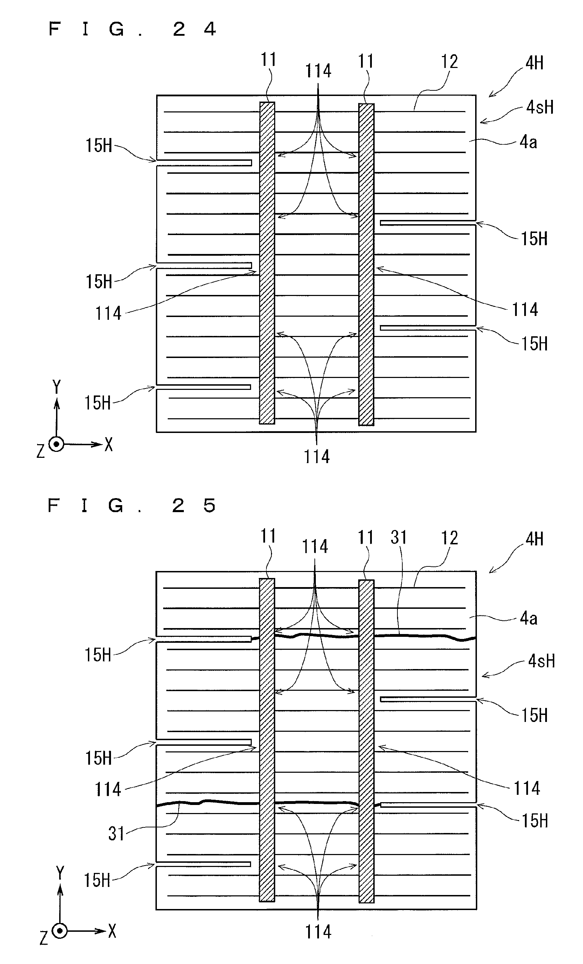

Further, in the first to fifth embodiments, the crack guiding part 15 is provided in the region located between the bus bar electrodes 11 as a pair of adjacent first electrodes in the case where the substrate body 4s, 4sA to 4sD, 4sBB is viewed through in plan view from the light-transmitting substrate 2 side, which is not limited thereto. For example, as shown in FIG. 24, there may be used a solar cell element 4H in which crack guiding parts 15H are each provided in the region between the pair of adjacent finger electrodes 12 as first electrodes in a case where a substrate body 4sH is viewed and viewed through in plan view from the first main surface 4a (that is, light-transmitting substrate 2 side).

In the solar cell element 4H, the crack guiding part 15H does not intersect the bus bar electrode 11 as a second electrode in a case where the substrate body 4sH is viewed and viewed through in plan view from the first main surface 4a (that is, light-transmitting substrate 2 side). For example, as shown in FIG. 24, the crack guiding part 15H may be configured to include a penetration part as in the second embodiment, or may include any configuration of a groove part as in the first embodiment, a plurality of penetration holes or a plurality of hole parts arranged in a line as in the third embodiment, and a recess formed by the coating part 17 as in the fourth embodiment. It is preferable that the crack guiding part 15H be linearly extended along the longitudinal direction (in FIG. 24, extending direction of the finger electrode 12) of the region between a pair of adjacent finger electrodes 12.

In the solar cell element 4H including the above-mentioned configuration, a stress concentrating part on which a stress is concentrated is generated in the portions (in this case, the tip of the crack guiding part 15H and a vicinity thereof) forming the crack guiding part 15H of the substrate body 4sH, upon application of the pressing force from the light-transmitting substrate 2 side. Accordingly, a crack tends to occur preferentially on the extended line in the extending direction of the crack guiding part 15H and, as shown in FIG. 25, a crack 31 occurs preferentially in a region between a pair of finger electrodes 12 in which the crack guiding part 15H is provided, along the longitudinal direction of the region. That is, the crack guiding part 15H guides a crack in a predetermined direction such that a crack occurs at a position at which the finger electrode 12 is not split.

As shown in FIG. 25, even when a crack occurs in the portions directly below the bus bar electrodes 11 of the substrate body 4sH, the power collected by the bus bar electrodes 11 can be efficiently transmitted to the connecting conductor 5 as long as the connecting conductor 5 is secured to almost the entire surfaces of the bus bar electrodes 11. Alternatively, as another method, the connecting conductor 5 may be secured, by spot welding or the like, to the surfaces of the bus bar electrodes 11 except for portions 114 in which the crack guiding part 15H guides an occurrence of a crack in the substrate body 4sH. In other words, in a case where the substrate body 4sH is viewed and viewed through in plan view from the first main surface 4a (that is, light-transmitting substrate 2 side), the connecting conductor 5 is partially secured to the bus bar electrodes 11 except for the portions 114 located on the extended line in the extending direction of the crack guiding part 15H, with the crack guiding part 15H being a reference. In such a manner, even when the bus bar electrode 11 is disconnected, conduction is secured owing to the presence of the connecting conductor 5, which reduces an output drop of the solar cell element 4H. In a case where the crack guiding part 15H is formed to include, for example, a groove part, the crack guiding part 15H may be extended up to the portion directly below the bus bar electrode 11.

The crack guiding parts 15, 15C are provided on the second main surface 4b side of the substrate body 4s and 4sC in the first and forth embodiments, which is not limited thereto. For example, a configuration in which the crack guiding parts 15, 15C are provided on the first main surface 4a side of the substrate body 4s, 4sC is also conceivable. In this case, when the substrate body 4s, 4sC is viewed in plan view from the first main surface 4a side (that is, light-transmitting substrate 2 side), the crack guiding parts 15, 15C are provided in the region located between a pair of adjacent bus bar electrodes 11. Therefore, it suffices that the crack guiding parts 15, 15C are provided on at least one main surface side of the first main surface 4a side and the second main surface 4b side of the substrate body 4s, 4sC.

In a case where the crack guiding parts 15, 15C are provided on the first main surface 4a side of the substrate body 4s, 4sC, a stress is less likely to be applied in the direction in which an aperture portion of the groove part or recess forming the crack guiding part 15, 15C spreads even when own weight or the load of snow or the like is applied to the solar cell element 4, 4C from the light-transmitting substrate 2 side. Accordingly, a crack along the crack guiding part 15, 15C occurs preferentially when a crack occurs while maintaining the strength of the solar cell element 4, 4C as much as possible. That is, according to the above-mentioned crack guiding part 15, 15C, an occurrence of a crack is not induced in a case where the solar cell element 4, 4C is bent by a small amount upon application of the load to the solar cell element 4, 4C from the light-transmitting substrate 2 side, and when the solar cell element 4, 4C is bent to some extent, it is possible to allow a crack to spread in a desired region and in a desired direction.

Meanwhile, in terms of maintaining power generation efficiency in the solar cell module 1, 1C by securing a light-receiving area, it is preferable that the crack guiding parts 15, 15C be provided on the second main surface 4b side of the substrate body 4s, 4sC.

The crack guiding parts 15, 15C are extended in the region from one end to the other end of the substrate body 4s, 4sC along the longitudinal direction of a region positioned between a pair of adjacent bus bar electrodes 13 in the first and fourth embodiments, which is not limited thereto. For example, a configuration in which the crack guiding parts 15, 15C are extended in a part of the region from one end to the other end of the substrate body 4s, 4sC is also conceivable. In particular, in terms of controlling the position at which a crack occurs preferentially with more reliability, the crack guiding parts 15, 15C are preferably extended in a longer portion from one end to the other end of the substrate body 4s, 4sC, and more preferably extended from one end to the other end of the substrate body 4s, 4sC.

The crack guiding parts 15, 15A, 15D, 15E are linearly disposed in the first, second and fifth embodiments, which is not limited thereto. The crack guiding parts 15, 15A, 15D, 15E may be extended while being tilted to some extent or may be extended while being curved to some extent with respect to the longitudinal direction of the region between a pair of adjacent bus bar electrodes 11. For example, when a pair of adjacent bus bar electrodes 11 are disposed in an approximately parallel manner, in order to generate a crack between a pair of adjacent bus bar electrodes 11 with more reliability, it is preferable that the crack guiding parts 15, 15A, 15D, 15E be extended along the longitudinal direction of the region between a pair of adjacent bus bar electrodes 11. Further, in order to reduce a possibility that a crack may spread in the direction different from the extending direction of the bus bar electrode 11, it is preferable that the crack guiding parts 15, 15A, 15D, 15E be linearly disposed.

The crack guiding parts 15 are each provided in the region positioned between a pair of adjacent bus bar electrodes 11 in the first to fifth embodiments, which is not limited thereto. For example, in a case where three or more of bus bar electrodes 11 are provided and there are a plurality of pairs of adjacent bus bar electrodes 11, the crack guiding part 15 15A, 15B, 15BB, 15C to 15E may be provided in the region positioned between at least a pair of bus bar electrodes 11 among a plurality of pairs of bus bar electrodes 11 or in the vicinity thereof.

The groove part included in the crack guiding part 15 and the hole part included in the crack guiding part 15BB are provided in the portion extending from the surface of the collector electrode 14 to the substrate body 4s, 4sBB in the depth direction in the first and third embodiments, which is not limited thereto. For example, it may have a depth so as not to reach the substrate body 4s, 4sBB.

While the finger electrodes 12 are provided in the first to fifth embodiments, for example, a configuration in which the finger electrodes 12 are not provided is also conceivable. In terms of enhancing power collecting efficiency, however, it is preferable that the finger electrode 12 as a second electrode be provided. Alternatively, in terms of stably obtaining high power collecting efficiency, more preferably, a plurality of finger electrodes 12 are electrically connected to each bus bar electrode 11. Still alternatively, a transparent conducting electrode comprised of ITO or the like may be provided as a second electrode over an entire surface of the first main surface 4a in place of the finger electrodes 12. Similarly in the case where the finger electrode 12 is provided as a second electrode, power collecting efficiency is also enhanced by the presence of the above-mentioned transparent conducting electrode provided as a second electrode, irrespective of the distance between the bus bar electrode 11 and the position at which a crack occurs.

The collector electrode 14 is separately provided on the second main surface 4b of the substrate body 4s, 4sA to 4sD, 4sBB in the first to fifth embodiments, which is no limited thereto. For example, the collector electrode 14 may be contained in the substrate body 4s, 4sA to 4sD, 4sBB. In this case, the crack guiding part 15D, 15E directly abuts against the substrate body 4sD.

Needless to say, it is possible to appropriately combine the entire or a part of the configurations constituting the first to fifth embodiments and various modifications described above to the extent not inconsistent with each other. For example, there may be adopted the configuration in which at least one of a plurality of penetration holes linearly arranged, a plurality of hole parts (groove parts) with bottoms linearly arranged, and a groove part and a recess linearly provided is provided between two penetration parts provided approximately in a line as shown in FIG. 6 and FIG. 7.

### Description of Reference Symbols

- 1, 1A to 1D: solar cell module
- 4, 4A to 4H, 4BB: solar cell element
- 4s, 4sA to 4sD, 4sF to 4sH, 4sBB: substrate body
- 5: connecting conductor
- 6, 6A to 6D: solar cell string
- 11, 13: bus bar electrode
- 12: finger electrode
- 14: collector electrode
- 15, 15A to 15H, 15BB: crack guiding part
- 17: coating part
- 31: crack

## Claims

1. A solar cell element, comprising:
a substrate body including a photoelectric conversion part;
a plurality of first electrodes located at intervals on one main surface of the substrate body; and
a crack guiding part located in a region positioned between a pair of adjacent first electrodes among the plurality of first electrodes when the substrate body is viewed or viewed through in plan view from the one main surface side and configured to guide a position of a crack occurring in the substrate body upon application of a load to the substrate body.

2. The solar cell element according to Claim 1, wherein the crack guiding part comprises a groove part located in the substrate body.

3. The solar cell element according to Claim 1, wherein the crack guiding part comprises a penetration part located in the substrate body.

4. The solar cell element according to Claim 3, wherein the penetration part comprises a plurality of penetration holes arranged in a line.

5. The solar cell element according to Claim 1, wherein the crack guiding part comprises at least one of a first support being in direct or indirect contact with the substrate body and a second support being in direct or indirect contact with the substrate body upon application of a load to the substrate body.

6. The solar cell element according to Claim 1, further comprising a coating part applied onto the substrate body directly or through another layer,
wherein the crack guiding part comprises a recess formed in the coating part.

7. The solar cell element according to Claim 1, further comprising a coating part applied onto the substrate body directly or through another layer,
wherein the crack guiding part is a non-forming part onto which the coating part is not applied.

8. The solar cell element according to any one of Claims 1 to 7, wherein:
the substrate body includes a first main surface forming a light-receiving surface on a front surface side of the substrate body and a second main surface forming a non-light-receiving surface on a back surface side of the substrate body; and
the crack guiding part is disposed on the second main surface side.

9. The solar cell element according to any one of Claims 1 to 8, wherein the crack guiding part is linearly shaped.

10. The solar cell element according to any one of Claims 1 to 9, wherein:
the first electrode is a linearly shaped; and
the crack guiding part extends along a longitudinal direction of the first electrode.

11. A solar cell element, comprising:
a substrate body of a rectangular or square shape, including a photoelectric conversion part; and
a plurality of first electrodes located at intervals on one main surface of the substrate body, wherein:
the plurality of first electrodes are provided so as to extend along one side of the substrate body; and
the substrate body comprises, in a region located between a pair of adjacent first electrodes among the plurality of first electrodes, at least one of a groove part and a penetration part located along a longitudinal direction of the first electrode when the substrate body is viewed or viewed through in plan view from the one main surface side.

12. The solar cell element according to Claim 11, wherein:
the substrate body includes a first main surface forming a light-receiving surface on a front surface side of the substrate body and a second main surface forming a non-light-receiving surface on a back surface side of the substrate body; and
the groove part is disposed on the second main surface side.

13. The solar cell element according to Claim 11 or 12, wherein the groove part is linearly shaped.

14. The solar cell element according to Claim 11, wherein the penetration part comprises a plurality of penetration holes arranged in a line.

15. The solar cell element according to any one of Claims 1 to 14, further comprising a second electrode located on the one main surface of the substrate body and electrically connected to the first electrode.

16. A solar cell module, comprising:
a plurality of the solar cell elements according to any one of Claims 1 to 15; and
a connecting conductor electrically connecting the adjacent solar cell elements among the plurality of solar cell elements.
